# EUROPÄISCHE PATENTSCHRIFT

(11) **EP 2 230 763 B1**
(45) Veröffentlichungstag und Bekanntmachung des Hinweises auf die Patenterteilung: **04.11.2015**
(21) Anmeldenummer: 10001297.0
(22) Anmeldetag: 09.02.2010
(51) Int. Cl.: H03G 3/34

(54) **Kompensation der Modulationsgradabhängigkeit einer Rauschsperre für digitale Hochfrequenzempfänger**
Compensation for the modulation level dependence of a noise limiter for digital high frequency receivers
Compensation de la dépendance du degré de modulation d'un silencieux pour récepteur numérique à haute fréquence

(30) Priorität: 12.03.2009 DE 102009012753
(43) Veröffentlichungstag der Anmeldung: 22.09.2010
(73) Patentinhaber: Rohde & Schwarz GmbH & Co. KG, 81671 München (DE)
(72) Erfinder: Schmidt, Jürgen, 85221 Dachau (DE); Simmler, Andreas, 80636 München (DE)
(74) Vertreter: Körfer, Thomas

(56) Entgegenhaltungen:
- EP-A2- 1 843 467
- DE-A1- 19 860 402
- DE-A1- 19 937 199

## Beschreibung

Die Erfindung betrifft eine Raussperre und ein Verfahren zum Rauschsperren für digitale Hochfrequenzempfänger.

Herkömmlich wird zur Rauschunterdrückung in digitalen Hochfrequenzempfängern der Pegel des Hochfrequenzsignals herangezogen. Oberhalb einer bestimmten Schwelle wird der Audio-Ausgang des Hochfrequenzempfängers aktiviert. Unterhalb der Schwelle wird der Audio-Ausgang deaktiviert.

Nachteilhaft ist hier jedoch, dass der Audio-Ausgang auch dann aktiviert wird, wenn der hohe Pegel lediglich auf einen hohen Rausch-Pegel zurückzuführen ist.

Dieses Problem wird teilweise gelöst durch eine Berücksichtigung der differentiellen Phase des demodulierten Hochfrequenzsignals. Bei hohem Phasenrauschen wird der Audio-Ausgang trotz hohen Pegels deaktiviert. So zeigt die DE 199 37 199 A1 eine solche Rauschsperre.

Nachteilhaft ist hier jedoch, dass insbesondere bei sehr geringen Amplitudenwerten des Hochfrequenzsignals bereits kleine absolute Rauschpegel zu einer hohen differentiellen Phase führen. Der Audio-Ausgang wird somit fälschlicherweise zu früh deaktiviert.

Der Erfindung liegt die Aufgabe zu Grunde, eine Raussperre und ein Verfahren zur Rauschsperrung zu schaffen, welche eine zuverlässige Rauschsperrung bei geringem Aufwand ermöglichen.

Bei einer Rauschsperre für digitale Hochfrequenzempfänger gemäß der DE 199 37 199 A1 wird aus der differenziellen Phase des digitalen Basisbandsignals nach einer Hochpassfilterung der absolute Betrag des Phasenrauschens bestimmt, der dann über einen den Empfindlichkeitsbereich bestimmenden Begrenzer und nach Bildung des Mittelwertes einer Vergleichseinrichtung zugeführt und dort mit einem eistellbaren Sollwert verglichen wird; bei Unterschreitung dieses Sollwertes wird über die Vergleichseinrichtung der Audio-Ausgang des Empfängers stummgeschaltet.

Die Aufgabe wird erfindungsgemäß für die Vorrichtung durch die Merkmale des unabhängigen Anspruchs 1 und für das Verfahren durch die Merkmale des unabhängigen Anspruchs 7 gelöst. Vorteilhafte Weiterbildungen sind Gegenstand der hierauf rückbezogenen Unteransprüche.

Eine erfindungsgemäße Rauschsperre für digitale Hochfrequenzempfänger beinhaltet eine Stummschaltungs-Einrichtung und eine Phasenrauschen-Bestimmungs-Einrichtung. Die Phasenrauschen-Bestimmungs-Einrichtung bestimmt aus einer differentiellen Phase eines von dem Hochfrequenzempfänger empfangenen Hochfrequenzsignals einen Mittelwert des Phasenrauschens. Die Stummschaltungs-Einrichtung schaltet einen Audio-Ausgang des Hochfrequenzempfängers in Abhängigkeit des Mittelwerts des Phasenrauschens stumm. Die Rauschsperre beinhaltet weiterhin eine Amplituden-Verarbeitungs-Einrichtung, welche die momentane Amplitude eines digitalen Basisbandsignals mit einem Parameter vergleicht oder ein Verhältnis der momentanen Amplitude und des Parameters bestimmt. Die Stummschaltungs-Einrichtung schaltet den Audio-Ausgang des Hochfrequenzempfängers in Abhängigkeit des Parameters und der momentanen Amplitude stumm. So wird eine vorzeitige Stummschaltung vermieden.

Die Phasenrauschen-Bestimmungs-Einrichtung aktualisiert den Mittelwert des Phasenrauschens bevorzugt, wenn die momentane Amplitude höher ist als der Parameter. Die Phasenrauschen-Bestimmungs-Einrichtung belässt den Mittelwert des Phasenrauschens bevorzugt auf seinem vormaligen Wert, wenn die momentane Amplitude des digitalen Basisbandsignals niedriger ist als der Parameter. Bei geringen Amplituden wird somit eine Stummschaltung auch bei hohem Phasenrauschen unterdrückt. Die Verständlichkeit von Übertragungen wird dadurch deutlich verbessert.

Alternativ gewichtet die Phasenrauschen-Bestimmungs-Einrichtung bei der Bestimmung des Mittelwerts des Phasenrauschens momentane Werte des Phasenrauschens mit dem Verhältnis der momentanen Amplitude des digitalen Basisbandsignals und des Parameters. So wird eine noch genauere Steuerung der Abschaltung des Audio-Ausgangs ermöglicht.

Vorteilhafterweise stellt die Amplituden-Verarbeitungs-Einrichtung den Parameter in Abhängigkeit eines gewünschten Signal-Rausch-Verhältnisses des Hochfrequenzsignals ein. So wird für unterschiedliche gewünschte Signal-Rausch-Verhältnisses ein weitgehend von dem Modulationsgrad unabhängiger Öffnungspunkt der Rauschsperre gewährleistet.

Bevorzugt weist die Amplituden-Verarbeitungs-Einrichtung bei einem hohen gewünschten Signal-Rausch-Verhältnis dem Parameter einen hohen Wert zu. Bevorzugt weist die Amplituden-Verarbeitungs-Einrichtung bei einem niedrigen gewünschten Signal-Rausch-Verhältnis dem Parameter einen niedrigen Wert zu. So wird der Einfluss des Modulationsgrads auf den Signal/Rauschen-Öffnungspunkt der Stummschaltung deutlich verringert.

Vorteilhafterweise ist das von dem Hochfrequenzempfänger empfangene Signal amplitudenmoduliert. So kann eine genaue Abschaltung des Audio-Ausgangs realisiert werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: erste beispielhafte Signalverläufe;
- Fig. 2: zweite beispielhafte Signalverläufe;
- Fig. 3: ein erstes Ausführungsbeispiel der erfindungsgemäßen Vorrichtung;
- Fig. 4: ein zweites Ausführungsbeispiel der erfindungsgemäßen Vorrichtung;
- Fig. 5: ein Ablaufdiagramm eines ersten Ausführungsbeispiels des erfindungsgemäßen Verfahrens, und
- Fig. 6: ein Ablaufdiagramm eines zweiten Ausführungsbeispiels des erfindungsgemäßen Verfahrens.

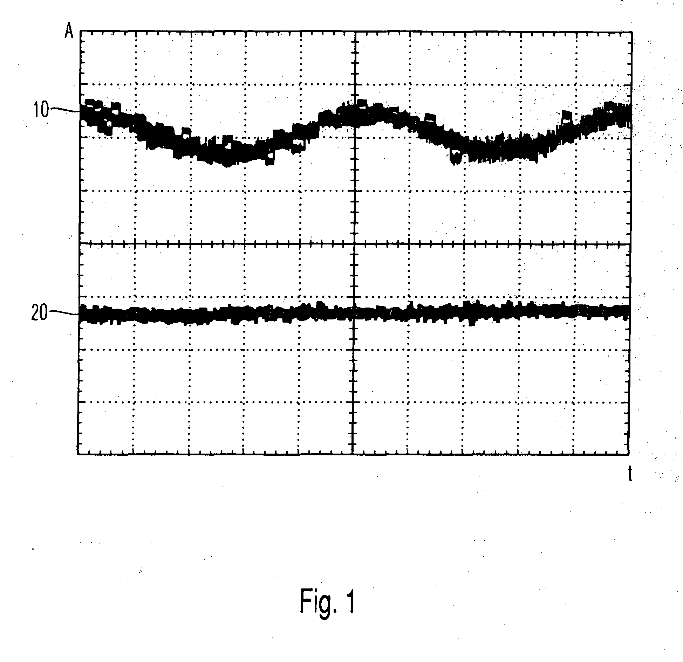

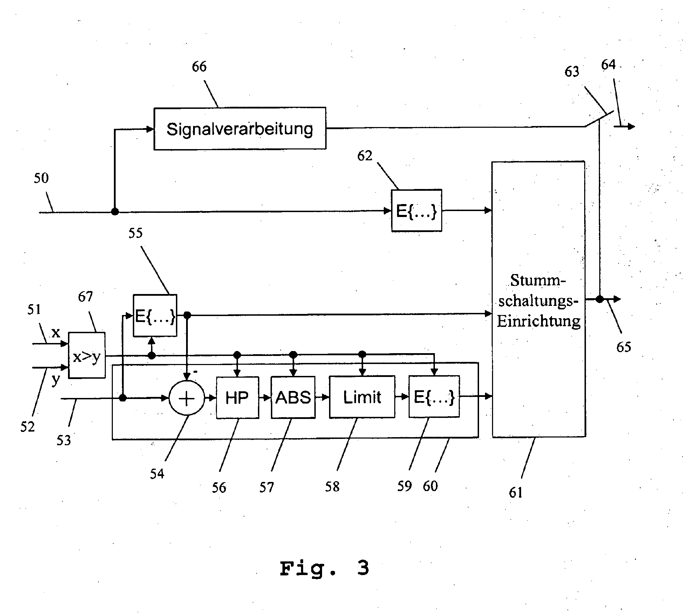

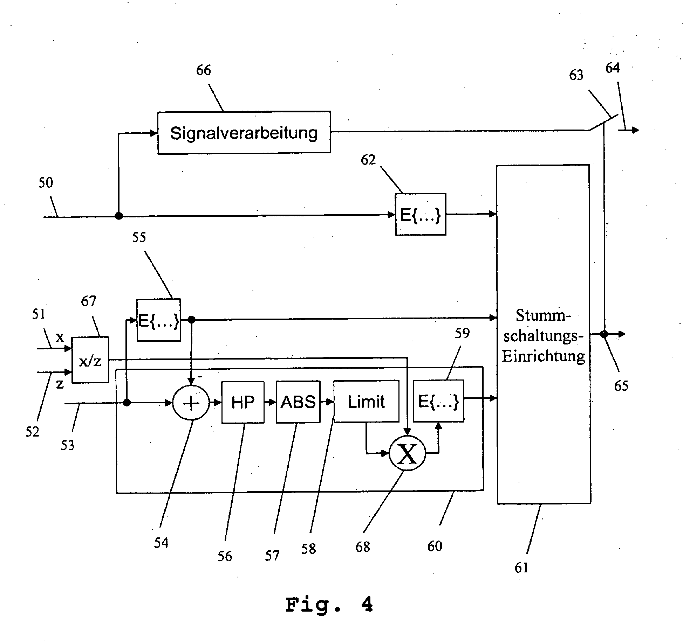

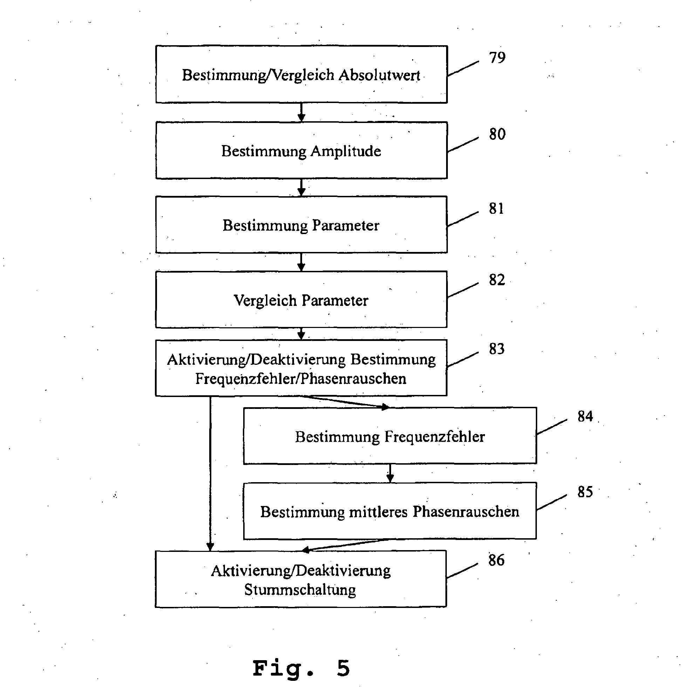

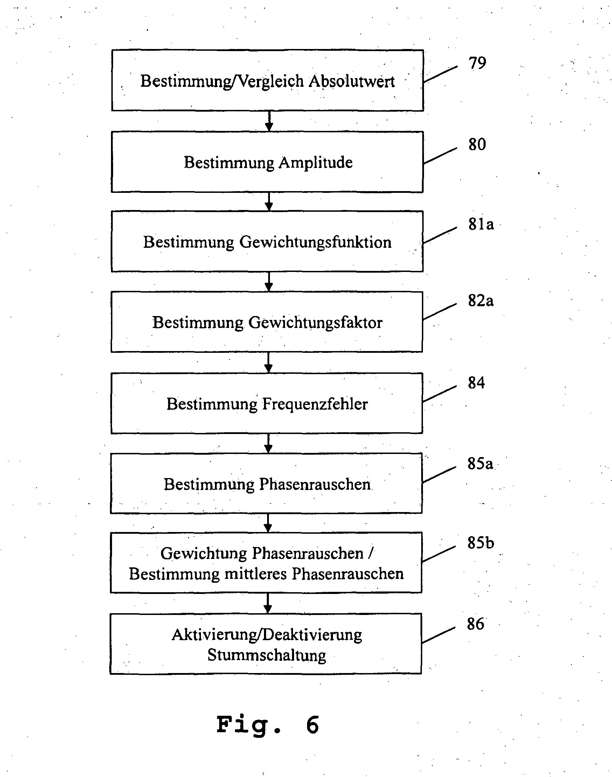

Zunächst wird anhand der Fig. 1 - 2 die der Erfindung zugrundeliegende Problematik erläutert. Anhand der Fig. 3 und Fig. 4 wird der Aufbau und die Funktionsweise der erfindungsgemäßen Rauschsperre gezeigt. Mittels Fig. 5 und Fig. 6 wird abschließend die Funktionsweise des erfindungsgemäßen Verfahrnes verdeutlicht. Identische Elemente werden in ähnlichen Abbildungen zum Teil nicht wiederholt dargestellt und beschrieben.

Fig. 1 zeigt einen ersten beispielhaften Signalverlauf der Amplitude A als Funktion der Zeit t. So zeigt die Kurve 10 die Amplitude der Hüllkurve eines amplitudenmodulierten Signals mit einem Modulationsgrad von 30%. D.h. das Trägersignal wird durch die Modulation um 30% in seiner Amplitude verändert. Das Signal weist stets eine Amplitude von zumindest 70% der Maximalamplitude auf, da der Träger um maximal um 30% in seiner Amplitude reduziert wird. Die Kurve 20 zeigt die differentielle Phase des demodulierten Signals. Es weist lediglich eine geringe Amplitude auf. Ein auf das amplitudenmodulierte Signal aufgeschlagenes Rauschsignal hat lediglich geringen Einfluss auf die differentielle Phase, da die stets hohe Amplitude des Trägers Phasensprünge verhindert.

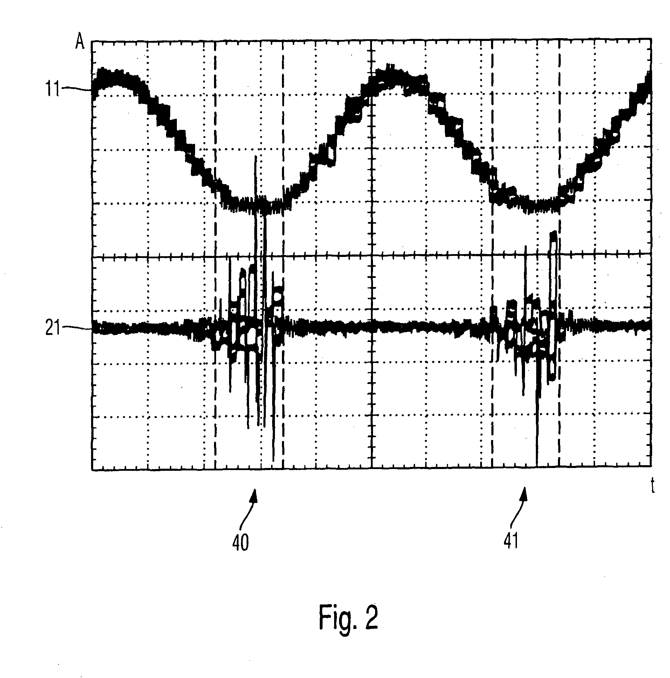

In Fig. 2 wird ein zweiter beispielhafter Signalverlauf der Amplitude A der Hüllkurve eines Hochfrequenzsignals als Funktion der Zeit t dargestellt. Hier beträgt der Modulationsgrad jedoch 95%. D.h. das Trägersignal wird durch die Modulation um 95% in seiner Amplitude verändert. Die Kurve 21 zeigt die differentielle Phase des demodulierten Signals. Es weist in den Bereichen 40, 41 geringer Amplitude der Hüllkurve des amplitudenmodulierten Signals (Kurve 11) eine sehr hohe Amplitude auf. Auf Grund der sehr geringen Amplitude des amplitudenmodulierten Signals in diesem Bereichen 40, 41 verursacht bereits geringes Rauschen sehr starke Änderungen der differentiellen Phase und damit große Phasensprünge.

Üblicherweise führt dies zu einer deutlichen Anhebung des Mittelwerts des Phasenrauschens. Dies führt bei hohen Modulationsgraden zu einer fälschlichen Abschaltung des Audio-Ausgangs bei geringen momentanen Amplituden des demodulierten Signals.

Fig. 3 zeigt ein erstes Ausführungsbeispiel der erfindungsgemäßen Vorrichtung. Ein erster Eingang 50 ist mit dem Hochfrequenzsignal beaufschlagt. In einer Signalverarbeitungseinrichtung 66 wird das Signal demoduliert und einem Schalter 63 zugeführt, welcher einen Audio-Ausgang 64 des Hochfrequenzempfängers schaltet. Der Absolutwert des Hochfrequenzsignals wird weiterhin einer Mittelwertbildungs-Einrichtung 62 zugeführt. Diese bestimmt die mittlere Amplitude des Signals und leitet sie oder ein davon abgeleitetes Signal an eine Stummschaltungs-Einrichtung 61 weiter.

Die differentielle Phase des Hochfrequenzsignals wird einem Eingang 53 zugeführt. Von dort wird es einer Mittelwertbildungs-Einrichtung 55 zugeführt. Die Mittelwertbildungs-Einrichtung 55 bestimmt den mittleren Frequenzfehler des Signals und leitet ihn oder ein davon abgeleitetes Signal an die Stummschaltungs-Einrichtung 61 weiter.

Weiterhin wird das Signal von dem Eingang 53 an einen Addierer 54 weitergeleitet, welcher zu dem Signal den negativen von der Mittelwertbildungs-Einrichtung 55 bestimmten mittleren Frequenzfehler addiert. Das resultierende Signal wird an einen Hochpassfilter 56 weitergeleitet, welcher niederfrequente Anteile aus dem Signal entfernt. Das resultierende Signal wird einer Absolutwertbildungs-Einrichtung 57 zugeführt, welche den Betrag des Signals bildet und an einen Begrenzer 58 weiterleitet. Der Begrenzer 58 limitiert den Wertebereich des Signals und leitet es an die Mittelwertbildungs-Einrichtung 59 weiter. Der Mittelwert des Signals wird anschließend an die Stummschaltungs-Einrichtung 61 weitergeleitet.

Das demodulierte Hochfrequenzsignal wird weiterhin über einen Eingang 51 einer Amplituden-Verarbeitungs-Einrichtung 67 zugeführt. Die Amplituden-Verarbeitungs-Einrichtung 67 vergleicht das demodulierte amplitudenmodulierte Hochfrequenzsignal mit einem über einen Eingang 52 zugeführten Parameter y. Ist die Amplitude x des demodulierten Hochfrequenzsignals größer als der Parameter y, so gibt die Amplituden-Verarbeitungs-Einrichtung 67 ein aktivierendes Signal ab. Ist die Amplitude x des demodulierten Hochfrequenzsignals kleiner als der Parameter y, so gibt die Amplituden-Verarbeitungs-Einrichtung 67 ein deaktivierendes Signal ab.

Der Parameter y wird dabei in Abhängigkeit eines gewünschten Signal-Rausch-Verhältnisses des Hochfrequenzsignals bestimmt. Ein niedriges gewünschtes Signal-Rausch-Verhältnis führt zu einem niedrigen Wert des Parameters y. Ein hohes gewünschtes Signal-Rausch-Verhältnis führt zu einem hohen Wert des Parameters y.

Das aktivierende Signal bzw. deaktivierende Signal wird der Mittelwertbildungs-Einrichtung 55, dem Addierer 54, dem Hochpass 56, der Absolutwertbildungs-Einrichtung 57, dem Begrenzer 58 und der Mittelwertbildungs-Einrichtung 59 zugeführt. Ein aktivierendes Signal aktiviert diese Bauelemente. Die Signalverarbeitung wird somit aktiviert. Ein deaktivierendes Signal deaktiviert stoppt die Signalverarbeitung. D.h. lediglich bei einem aktivierenden Signal werden neue Mittelwerte Phasenrauschen bestimmt und an die Stummschaltungs-Einrichtung 61 übertragen.

Die Stummschaltungs-Einrichtung 61 schaltet unter bestimmten Umständen den Audio-Ausgang 64 des Hochfrequenzempfängers stumm. Wenn die Stummschaltungs-Einrichtung 61 von der Mittelwertbildungs-Einrichtung 62 ein Signal erhält, welches eine Amplitude oberhalb einer bestimmten Schwelle anzeigt, so aktiviert sie stets den Audio-Ausgang 64 unabhängig von weiteren Signalen. Ist die Amplitude unterhalb der Schwelle, so bestimmen weitere Signale, welche die Stummschaltungs-Einrichtung empfängt, ob sie den Audio-Ausgang 64 aktiviert oder deaktiviert.

Wenn die Stummschaltungs-Einrichtung 61 von der Mittelwertbildungs-Einrichtung 55 ein Signal erhält, welches einen mittleren Frequenzfehler über einer bestimmten Schwelle anzeigt, so deaktiviert sie den Audio-Ausgang 64, sofern die von der Mittelwertbildungs-Einrichtung 62 übermittelte Amplitude nicht einen bestimmten Wert überschreitet. Weiterhin deaktiviert die Stummschaltungs-Einrichtung 61 den Audio-Ausgang 64, wenn der von der Mittelwertbildungs-Einrichtung 59 übertragene Wert des mittleren Phasenrauschens eine bestimmte Schwelle überschreitet, sofern der von die Mittelwertbildungs-Einrichtung 62 übermittelte Amplitude nicht einen bestimmten Wert überschreitet.

Dabei bestimmt die Mittelwertbildungs-Einrichtung 59 lediglich dann neue Werte und überträgt diese an die Stummschaltungs-Einrichtung 61, wenn sie ein aktivierendes Signal von der Amplituden-Verarbeitungs-Einrichtung 67 erhalten hat. Hat sie ein deaktivierendes Signal erhalten, so bestimmt sie den Mittelwert nicht länger und überträgt keine Werte an die Stummschaltungs-Einrichtung 61. Die Stummschaltungs-Einrichtung 61 arbeitet in diesem Fall mit dem zuletzt übertragenen Mittelwert weiter, bis neue Werte übertragen werden.

Fig. 4 zeigt ein zweites Ausführungsbeispiel der erfindungsgemäßen Vorrichtung. Das hier dargestellte Ausführungsbeispiel entspricht weitgehend dem in Fig. 3 dargestellten Ausführungsbeispiel.

Die Amplituden-Verarbeitungs-Einrichtung 67 gibt hier jedoch ein Signal aus, welches ein Verhältnis der Amplitude des demodulierten Hochfrequenzsignals x und des Parameters z anzeigt. Das von der Amplituden-Verarbeitungs-Einrichtung 67 erzeugte Verhältnissignal wird lediglich einem Multiplizierer 68 zugeführt, welcher der Mittelwertbildungs-Einrichtung 59 aus Fig. 3 vorgeschaltet ist.

Der Multiplizierer 68 multipliziert das Verhältnissignal mit dem verarbeiteten gegenwärtigen Phasenrauschen. D.h. das gegenwärtige Phasenrauschen wird mit dem Verhältnis der Amplitude des demodulierten Hochfrequenzsignals x und des Parameters z gewichtet, bevor es der Mittelwertbildungs-Einrichtung 59 zugeführt wird. So wird eine verbesserte Berücksichtigung des Verhältnisses erreicht.

Alternativ ist eine weitere Vorverarbeitung des Verhältnissignals möglich. So ist eine Quadrierung oder eine Invertierung des Verhältnissignals ebenfalls denkbar, um eine optimale Berücksichtigung des Verhältnisses zu erreichen.

In Fig. 5 ist ein erstes Ablaufdiagramm eines Ausführungsbeispiels des erfindungsgemäßen Verfahrens dargestellt. In einem ersten Schritt 79 wird der gegenwärtige Absolutwert des Hochfrequenzsignals bestimmt und mit einem Schwellwert verglichen. In einem zweiten Schritt 80 wird die momentane Amplitude des demodulierten Hochfrequenzsignals bestimmt. In einem dritten Schritt 81 wird ein Parameter bestimmt. Es handelt sich dabei um einen Schwellwert der momentanen Amplitude des demodulierten Hochfrequenzsignals. Er wird anhand eines gewünschten Signal-Rausch-Verhältnisses des Hochfrequenzsignals bestimmt. Ein hohes Signal-Rausch-Verhältnis resultiert in einem hohen Wert des Parameters. Ein niedriges Signal-Rausch-Verhältnis resultiert in einem niedrigen Wert des Parameters.

In einem vierten Schritt 82 wird die Amplitude des demodulierten Hochfrequenzsignals mit dem Parameter verglichen. Ist die Amplitude des demodulierten Hochfrequenzsignals größer als der Parameter, so wird eine logische 1 als Entscheidungswert gebildet. Ist die Amplitude des demodulierten Hochfrequenzsignals kleiner als der Parameter, so wird eine logische 0 als Entscheidungswert gebildet. In einem fünften Schritt wird anhand des Entscheidungswerts eine Bestimmung des Frequenzfehlers und des Phasenrauschens, welche in den Schritten 84 und 85 näher beschrieben werden, aktiviert bzw. deaktiviert. Bei einem Entscheidungswert von 1 werden sie aktiviert. Bei einem Entscheidungswert von 0 werden sie deaktiviert.

Sind die Bestimmung des Frequenzfehlers und des Phasenrauschens aktiviert, wird in einem sechsten Schritt 84 ausgehend von einem differentiellen Phasensignal, welches aus dem Hochfrequenzsignal gewonnen wird, der mittlere Frequenzfehler bestimmt. In einem siebten Schritt 85 wird weiterhin ebenfalls ausgehend von dem differentiellen Phasensignal das mittlere Phasenrauschen bestimmt.

Abschließend wird in einem achten Schritt 86 anhand des mittleren Absolutwerts des Hochfrequenzsignals, welcher in dem ersten Schritt 79 bestimmt wurde, gegebenenfalls anhand des mittleren Frequenzfehlers und des mittleren Phasenrauschens bestimmt, ob der Audio-Ausgang des Hochfrequenzempfängers stumm geschaltet wird. Dabei wird der Audio-Ausgang bei einem mittleren Absolutwert des Hochfrequenzsignals oberhalb eines Schwellwerts generell nicht stumm geschaltet. Wurden der mittlere Frequenzfehler und das mittlere Phasenrauschen bestimmt, so wird der Audio-Ausgang dann stumm geschaltet, wenn der Frequenzfehler und/oder das Phasenrauschen bestimmte Schwellwerte überschreiten.

In Fig. 6 ist ein zweites Ablaufdiagramm eines Ausführungsbeispiels des erfindungsgemäßen Verfahrens dargestellt. Das hier dargestellte Ausführungsbeispiel entspricht teilweise dem in Fig. 5 gezeigten Ausführungsbeispiel.

Wie auch bei dem in Fig. 5 gezeigten Ablauf wird in einem ersten Schritt 79 der gegenwärtige Absolutwert des Hochfrequenzsignals bestimmt und mit einem Schwellwert verglichen. In einem zweiten Schritt 80 wird auch hier die momentane Amplitude des demodulierten Hochfrequenzsignals bestimmt.

In einem dritten Schritt 81a wird die Gewichtungsfunktion, mit welcher die einzelnen Werte des Phasenrauschens gewichtet werden bestimmt. Sie wird anhand eines gewünschten Signal-Rausch-Verhältnisses des Hochfrequenzsignals bestimmt. Beispielsweise werden eine direkte Proportionalität und ein entsprechender Proportionalitätsfaktor hier ausgewählt. Auch eine quadratische Proportionalität und ein entsprechender Proportionalitätsfaktor können eingesetzt werden.

In einem vierten Schritt 82a wird ausgehend von dem jeweiligen Wert der Amplitude des demodulierten Hochfrequenzsignals der jeweilige Gewichtungsfaktor bestimmt. Hierzu wird die im dritten Schritt 81a bestimmte Gewichtungsfunktion genutzt.

Anschließend wird in einem fünften Schritt 84 ausgehend von dem differentiellen Phasensignal, welches aus dem Hochfrequenzsignal gewonnen wird, der mittlere Frequenzfehler bestimmt. In einem sechsten Schritt 85a wird weiterhin ebenfalls ausgehend von dem differentiellen Phasensignal das momentane Phasenrauschen bestimmt. In einem siebten Schritt 85b wird ausgehend von dem im vierten Schritt 82a bestimmten Gewichtungsfaktor und dem im sechsten Schritt bestimmten momentanen Phasenrauschen zunächst das momentane Phasenrauschen mit dem Gewichtungsfaktor gewichtet und anschließend das mittlere Phasenrauschen über eine Mehrzahl an Werten bestimmt.

Abschließend wird in einem achten Schritt 86 anhand des mittleren Absolutwerts des Hochfrequenzsignals, welcher in dem ersten Schritt 79 bestimmt wurde, gegebenenfalls anhand des mittleren Frequenzfehlers und des wie beschrieben bestimmten mittleren Phasenrauschens bestimmt, ob der Audio-Ausgang des Hochfrequenzempfängers stumm geschaltet wird. Dabei wird der Audio-Ausgang bei einem mittleren Absolutwert des Hochfrequenzsignals oberhalb eines Schwellwerts generell nicht stumm geschaltet. Überschreitet der mittlere Frequenzfehler einen bestimmten Wert, so wird der Audio-Ausgang stumm geschaltet, sofern der mittlere Absolutwert des Hochfrequenzsignals nicht oberhalb des Schwellwerts ist. Überschreitet das mittlere Phasenrauschen einen bestimmten Wert, so wird der Audio-Ausgang stumm geschaltet, es sei denn, der mittlere Absolutwert des Hochfrequenzsignals ist oberhalb des Schwellwerts.

Die Erfindung ist nicht auf das dargestellte Ausführungsbeispiel beschränkt. Wie bereits erwähnt, können unterschiedliche Kriterien zur Stummschaltung des Audio-Ausgangs eingesetzt werden, welche durch die erfindungsgemäße Amplituden-Verarbeitungs-Einrichtung geschalten werden.

## Patentansprüche

1. Rauschsperre für digitale Hochfrequenzempfänger, mit einer Stummschaltungs-Einrichtung (61) und einer Phasenrauschen-Bestimmungs-Einrichtung (60),
wobei die Phasenrauschen-Bestimmungs-Einrichtung (60) so ausgebildet ist, dass sie aus einer differentiellen Phase eines von dem Hochfrequenzempfänger empfangenen Hochfrequenzsignals einen Mittelwert des Phasenrauschens bestimmt und ein davon abgeleitetes Signal an die Stummschaltungs-Einrichtung (61) weiterleitet,
wobei die Stummschaltungs-Einrichtung (61) so ausgebildet ist, dass sie einen Audio-Ausgang (64) des Hochfrequenzempfängers in Abhängigkeit des Mittelwerts des Phasenrauschens stumm schaltet,
wobei die Rauschsperre weiterhin eine Amplituden-Verarbeitungs-Einrichtung (67) beinhaltet,
**dadurch gekennzeichnet,**
**dass** die Amplituden-Verarbeitungs-Einrichtung (67) so ausgebildet ist, dass sie eine momentane Amplitude (x) eines digitalen Basisbandsignals mit einem Parameter (y) vergleicht, wobei anhand des Entscheidungswerts des Vergleichs die Bestimmung des Mittelwerts des Phasenrauschens aktiviert bzw. deaktiviert wird,
oder dass die Amplituden-Verarbeitungs-Einrichtung (67) so ausgebildet ist, dass sie ein Verhältnis der momentanen Amplitude (x) und des Parameters (z) bestimmt und das Verhältnissignal der Phasenrauschen-Bestimmungs-Einrichtung (60) zuführt und bei der Bestimmung des Mittelwertes des Phasenrauschens momentane Werte des Phasenrauschens wichtet,
und **dass** die Stummschaltungs-Einrichtung (61) weiterhin so ausgebildet ist, dass sie den Audio-Ausgang (64) des Hochfrequenzempfängers in Abhängigkeit des Parameters (y, z) und der momentanen Amplitude (x) stumm schaltet.

2. Rauschsperre nach Anspruch 1,
**dadurch gekennzeichnet,**
**dass** die Phasenrauschen-Bestimmungs-Einrichtung (60) weiterhin so ausgebildet ist, dass sie den Mittelwert des Phasenrauschens aktualisiert, wenn die momentane Amplitude (x) höher ist als der Parameter (y), und dass die Phasenrauschen-Bestimmungs-Einrichtung (60) weiterhin so ausgebildet ist, dass sie den Mittelwert des Phasenrauschens auf seinem vormaligen Wert belässt, wenn die momentane Amplitude (x) des digitalen Basisbandsignals niedriger ist als der Parameter (y).

3. Rauschsperre nach Anspruch 1,
**dadurch gekennzeichnet,**
**dass** die Gewichtung mittels eines Multiplizierers (68) erfolgt, der so ausgebildet ist, dass er mit dem Verhältnis der momentanen Amplitude (x) des digitalen Basisbandsignals und des Parameters (z) gewichtet.

4. Rauschsperre nach Anspruch 2 oder 3,
**dadurch gekennzeichnet,**
**dass** die Amplituden-Verarbeitungs-Einrichtung (67) weiterhin so ausgebildet ist, dass sie den Parameter (y, z) in Abhängigkeit eines gewünschten Signal-Rausch-Verhältnisses des Hochfrequenzsignals einstellt.

5. Rauschsperre nach Anspruch 4,
**dadurch gekennzeichnet,**
**dass** die Amplituden-Verarbeitungs-Einrichtung (67) weiterhin so ausgebildet ist, dass sie bei einem hohen gewünschten Signal-Rausch-Verhältnis dem Parameter (y, z) einen hohen Wert zuweist, und dass die Amplituden-Verarbeitungs-Einrichtung (67) weiterhin so ausgebildet ist, dass sie bei einem niedrigen gewünschten Signal-Rausch-Verhältnis dem Parameter (y, z) einen niedrigen Wert zuweist.

6. Rauschsperre nach einem der Ansprüche 1 bis 5,
**dadurch gekennzeichnet,**
**dass** das von dem Hochfrequenzempfänger empfangene Signal amplitudenmoduliert ist.

7. Verfahren zur Rauschsperrung in digitalen Hochfrequenzempfängern,
wobei aus einer differentiellen Phase eines empfangenen Hochfrequenzsignals ein Mittelwert des Phasenrauschens bestimmt wird,
wobei ein Audio-Ausgang (64) des Hochfrequenzempfängers in Abhängigkeit des Mittelwerts des Phasenrauschens stumm geschaltet wird,
wobei eine momentane Amplitude (x) des digitalen Basisbandsignals mit einem Parameter (y) verglichen und anhand des Entscheidungswerts des Vergleichs die Bestimmung des Mittelwerts des Phasenrauschens aktiviert bzw. deaktiviert wird oder ein Verhältnis der momentanen Amplitude (x) und des Parameters (z) gebildet und daraus ein Gewichtungsfaktor bestimmt wird, mit welchem das Phasenrauschen gewichtet wird,
wobei bei der Bestimmung des Mittelwertes des Phasenrauschens momentane Werte des Phasenrauschens gewichtet werden, und
wobei der Audio-Ausgang (64) des Hochfrequenzempfängers in Abhängigkeit des Parameters (y, z) und der momentanen Amplitude (x) stumm geschaltet wird.

8. Verfahren nach Anspruch 7,
**dadurch gekennzeichnet,**
**dass** der Mittelwert des Phasenrauschens aktualisiert wird, wenn die momentane Amplitude (x) höher ist als der Parameter (y), und
**dass** der Mittelwert des Phasenrauschens auf seinem vormaligen Wert belassen wird, wenn die momentane Amplitude (x) des digitalen Basisbandsignals niedriger ist als der Parameter (y).

9. Verfahren nach Anspruch 7,
**dadurch gekennzeichnet,**
**dass** bei der Bestimmung des Mittelwerts des Phasenrauschens momentane Werte des Phasenrauschens mit dem Verhältnis der momentanen Amplitude (x) des digitalen Basisbandsignals und des Parameters (z) gewichtet werden.

10. Verfahren nach Anspruch 8 oder 9,
**dadurch gekennzeichnet,**
**dass** der Parameter (y, z) in Abhängigkeit eines gewünschten Signal-Rausch-Verhältnisses des Hochfrequenzsignals eingestellt wird.

11. Verfahren nach Anspruch 10,
**dadurch gekennzeichnet,**
**dass** bei einem hohen gewünschten Signal-Rausch-Verhältnis dem Parameter (y, z) ein hoher Wert zugewiesen wird, und dass bei einem niedrigen gewünschten Signal-Rausch-Verhältnis dem Parameter (y, z) einen niedrigen Wert zugewiesen wird.

12. Verfahren nach einem der Ansprüche 7 bis 11,
**dadurch gekennzeichnet,**
**dass** das empfangene Signal amplitudenmoduliert ist.

## Claims

1. Noise limiter for digital high frequency receivers, with a muting arrangement (61) and a phase noise determining arrangement (60),
wherein the phase noise determining arrangement (60) is configured so that it determines a mean value of the phase noise from a differential phase of a high frequency signal received by the high frequency receiver and passes a signal derived therefrom to the muting arrangement (61),
wherein the muting arrangement (61) is configured so that it mutes an audio output (64) of the high frequency receiver depending on the mean value of the phase noise, wherein the noise limiter also comprises an amplitude processing arrangement (67), **characterised in that**
the amplitude processing arrangement (67) is configured so that it compares an instantaneous amplitude (x) of a digital base band signal with a parameter (y), wherein the determination of the mean value of the phase noise is activated or deactivated according to the decision value of the comparison,
or **in that** the amplitude processing arrangement (67) is configured so that it determines a ratio of the instantaneous amplitude (x) and the parameter (z) and feeds the ratio signal to the phase noise determining arrangement (60) and when determining the mean value of the phase noise weights instantaneous values of the phase noise,
and **in that** the muting arrangement (61) is also configured so that it mutes the audio output (64) of the high frequency receiver depending on the parameter (y, z) and the instantaneous amplitude (x).

2. Noise limiter according to claim 1,
**characterised in that**
the phase noise determining arrangement (60) is also configured so that it updates the mean value of the phase noise when the instantaneous amplitude (x) is higher than the parameter (y), and **in that** the phase noise determining arrangement (60) is also configured so that it leaves the mean value of the phase noise at its previous value when the instantaneous amplitude (x) of the digital base band signal is lower than the parameter (y).

3. Noise limiter according to claim 1,
**characterised in that**
the weighting is carried out by means of a multiplier (68) which is configured so that it weights with the ratio of the instantaneous amplitude (x) of the digital base band signal and the parameter (z).

4. Noise limiter according to claim 2 or 3,
**characterised in that**
the amplitude processing arrangement (67) is also configured so that it sets the parameter (y, z) depending on a desired signal-to-noise ratio of the high frequency signal.

5. Noise limiter according to claim 4,
**characterised in that**
the amplitude processing arrangement (67) is also configured so that when a high signal-to-noise ratio is desired it allocates a high value to the parameter (y, z), and **in that** the amplitude processing arrangement (67) is also configured so that when a low signal-to-noise ratio is desired it allocates a low value to the parameter (y, z).

6. Noise limiter according to one of claims 1 to 5,
**characterised in that**
the signal received by the high frequency receiver is amplitude-modulated.

7. Method for limiting noise in digital high frequency receivers,
wherein a mean value of the phase noise is determined from a differential phase of a received high frequency signal,
wherein an audio output (64) of the high frequency receiver is muted depending on the mean value of the phase noise,
wherein an instantaneous amplitude (x) of the digital base band signal is compared with a parameter (y) and the determination of the mean value of the phase noise is activated or deactivated according to the decision value of the comparison or a ratio of the instantaneous amplitude (x) and the parameter (z) is formed and used to determine a weighting factor with which the phase noise is weighted,
wherein instantaneous values of the phase noise are weighted when determining the mean value of the phase noise, and
wherein the audio output (64) of the high frequency receiver is muted depending on the parameter (y, z) and the instantaneous amplitude (x).

8. Method according to claim 7,
**characterised in that**
the mean value of the phase noise is updated when the instantaneous amplitude (x) is higher than the parameter (y), and
**in that** the mean value of the phase noise is left at its previous value when the instantaneous amplitude (x) of the digital base band signal is lower than the parameter (y).

9. Method according to claim 7,
**characterised in that**
when determining the mean value of the phase noise instantaneous values of the phase noise are weighted with the ratio of the instantaneous amplitude (x) of the digital base band signal and the parameter (z).

10. Method according to claim 8 or 9,
**characterised in that**
the parameter (y, z) is set depending on a desired signal-to-noise ratio of the high frequency signal.

11. Method according to claim 10,
**characterised in that**
when a high signal-to-noise ratio is desired a high value is allocated to the parameter (y, z), and **in that** when a low signal-to-noise ratio is desired a low value is allocated to the parameter (y, z).

12. Method according to one of claims 7 to 11,
**characterised in that**
the received signal is amplitude-modulated.

## Revendications

1. Silencieux pour récepteurs numériques à haute fréquence, comportant un moyen de commutation sur muet (61) et un moyen de détermination de bruit de phase (60),
dans lequel le moyen de détermination de bruit de phase (60) est réalisé de sorte qu'il détermine une valeur moyenne du bruit de phase à partir d'une phase différentielle d'un signal haute fréquence reçu par le récepteur haute fréquence et transmet un signal qui en est dérivé au moyen de commutation sur muet (61),
dans lequel le moyen de commutation sur muet (61) est réalisé de sorte qu'il commute sur muet une sortie audio (64) du récepteur haute fréquence en fonction de la valeur moyenne du bruit de phase,
dans lequel le silencieux comporte en outre un moyen de transformation d'amplitude (67),
**caractérisé en ce que**
le moyen de transformation d'amplitude (67) est réalisé de sorte qu'il compare une amplitude momentanée (x) d'un signal numérique en bande de base à un paramètre (y), dans lequel, en fonction de la valeur de décision de la comparaison, la détermination de la valeur moyenne du bruit de phase est activée ou désactivée,
ou **en ce que** le moyen de transformation d'amplitude (67) est réalisé de sorte qu'il détermine un rapport de l'amplitude momentanée (x) et du paramètre (z) et délivre le signal de rapport au moyen de détermination de bruit de phase (60) et pondère les valeurs momentanées du bruit de phase lors de la détermination de la valeur moyenne du bruit de phase,
et **en ce que** le moyen de commutation sur muet (61) est réalisé en outre de sorte qu'il commute sur muet la sortie audio (64) du récepteur haute fréquence selon le paramètre (y, z) et l'amplitude momentanée (x).

2. Silencieux selon la revendication 1, **caractérisé en ce que**
le moyen de détermination de bruit de phase (60) est réalisé en outre de sorte qu'il actualise la valeur moyenne du bruit de phase, lorsque l'amplitude momentanée (x) est supérieure au paramètre (y), et **en ce que** le moyen de détermination de bruit de phase (60) est réalisé en outre de sorte qu'il laisse la valeur moyenne du bruit de phase à sa valeur précédente, lorsque l'amplitude momentanée (x) du signal numérique en bande de base est inférieure au paramètre (y).

3. Silencieux selon la revendication 1, **caractérisé en ce que**
la pondération est effectuée grâce à un multiplicateur (68) qui est réalisé de sorte qu'il est pondéré par le rapport de l'amplitude momentanée (x) du signal numérique en bande de base et du paramètre (z).

4. Silencieux selon la revendication 2 ou 3, **caractérisé en ce que**
le moyen de transformation d'amplitude (67) est réalisé en outre de sorte qu'il règle le paramètre (y, z) selon un rapport signal-bruit désiré du signal haute fréquence.

5. Silencieux selon la revendication 4, **caractérisé en ce que**
le moyen de transformation d'amplitude (67) est en outre réalisé de sorte qu'il alloue une valeur élevée au paramètre (y, z) dans le cas d'un rapport signal-bruit désiré élevé, et **en ce que** le moyen de transformation d'amplitude (67) est réalisé en outre de sorte qu'il alloue une valeur faible au paramètre (y, z) dans le cas d'un rapport signal-bruit désiré faible.

6. Silencieux selon la revendication 1 à 5, **caractérisé en ce que**
le signal reçu par le récepteur haute fréquence est modulé en amplitude.

7. Procédé pour le réglage silencieux dans des récepteurs numériques haute fréquence,
dans lequel une valeur moyenne du bruit de phase est déterminée à partir d'une phase différentielle d'un signal haute fréquence reçu,
dans lequel une sortie audio (64) du récepteur haute fréquence est commutée sur muet selon la valeur moyenne du bruit de phase,
dans lequel une amplitude momentanée (x) du signal numérique en bande de base est comparée à un paramètre (y) et la détermination de la valeur moyenne du bruit de phase est activée ou désactivée selon la valeur de décision de la comparaison ou un rapport de l'amplitude momentanée (x) et du paramètre (z) est formé et ainsi un facteur de pondération est déterminé, grâce auquel le bruit de phase est pondéré,
dans lequel des valeurs momentanées du bruit de phase sont pondérées lors de la détermination de la valeur moyenne du bruit de phase, et
dans lequel la sortie audio (64) du récepteur haute fréquence est commutée sur muet selon le paramètre (y, z) et l'amplitude momentanée (x).

8. Procédé selon la revendication 7, **caractérisé en ce que**
la valeur moyenne du bruit de phase est actualisée, lorsque l'amplitude momentanée (x) est supérieure au paramètre (y), et
**en ce que** la valeur moyenne du bruit de phase est laissée à sa valeur précédente, lorsque l'amplitude momentanée (x) du signal numérique en bande de base est inférieure au paramètre (y).

9. Procédé selon la revendication 7, **caractérisé en ce que**, lors de la détermination de la valeur moyenne du bruit de phase, des valeurs momentanées du bruit de phase sont pondérées grâce au rapport de l'amplitude momentanée (x) du signal numérique en bande de base et du paramètre (z).

10. Procédé selon la revendication 8 ou 9, **caractérisé en ce que**
le paramètre (y, z) est réglé selon un rapport signal-bruit désiré du signal haute fréquence.

11. Procédé selon la revendication 10, **caractérisé en ce que**
dans le cas d'un rapport signal-bruit désiré élevé, une valeur élevée est allouée au paramètre (y, z), et
**en ce que**, dans le cas d'un rapport signal-bruit désiré faible, une valeur faible est allouée au paramètre (y, z).

12. Procédé selon la revendication 7 à 11, **caractérisé en ce que**
le signal reçu est modulé en amplitude.
